# EUROPEAN PATENT APPLICATION

(11) **EP 4 653 886 A1**
(43) Date of publication of application: **26.11.2025**
(21) Application number: 25172159.3
(22) Date of filing: 24.04.2025
(51) Int. Cl.: G01R 31/3185

(54) **PRIMARY DIE AND TEST METHOD**

(30) Priority: 09.05.2024 CN 202410572807
(71) Applicant: Huawei Technologies Co., Ltd., Shenzhen, Guangdong 518129 (CN)
(72) Inventor: Cui, Changming, Shenzhen, 518129 (CN); Xu, Tuanhui, Shenzhen, 518129 (CN)
(74) Representative: Thun, Clemens

(57) **Abstract**

Embodiments of this application provide a primary die and a test method, and relate to the field of chip technologies, so that package pins of a chiplet are reduced, a test link is shortened, and test efficiency is improved. A specific solution is as follows: The primary die includes a PTAP, a first STAP, and a second STAP. The first STAP is coupled to the first secondary die, and the second STAP is coupled to the second secondary die. A TDI port of the PTAP is coupled to a TDI port of the first STAP. The TDI port of the PTAP is further coupled to a first data input end of an input selection circuit. A second data input end of the input selection circuit is coupled to a TDO port of the first STAP. An output end of the input selection circuit is coupled to a TDI port of the second STAP. The TDO port of the first STAP is coupled to a first data input end of an output selection circuit. A TDO port of the second STAP is coupled to a second data input end of the output selection circuit. An output end of the output selection circuit is coupled to a TDO port of the PTAP. The output selection circuit is configured to select an output test result of the first STAP or an output test result of the second STAP for output.

## Description

### TECHNICAL FIELD

Embodiments of this application relate to the field of chip technologies, and in particular, to a primary die and a test method.

### BACKGROUND

In a design for testability (design for testability, DFT) of a chip, a common test interface is a joint test action group (joint test action group, JTAG). The JTAG includes a plurality of pins such as test clock input (test clock input, TCK), test mode selection input (test mode selection input, TMS), test data input (test data input, TDI), test data output (test data output, TDO), and test reset input (test reset input, TRST). During a test, the chip may control a state machine of an internal test access port (test access port, TAP) through the JTAG. The chip may further control test configuration input and test result observation of a memory build-in-self test (memory build-in-self test, MBIST) and an intellectual property core (intellectual property core, IP).

However, for a chiplet (chiplet), each die (die) includes a JTAG TAP state machine. If a JTAG pin of each die is led out of package, resource overheads for package pins are high. In addition, some dies are not directly connected to an external device. JTAG pins of these dies cannot be directly led out of package, and these dies need to be connected to package pins through another die. As a result, design difficulty of the another die is increased.

### SUMMARY

Embodiments of this application provide a primary die and a test method, so that package pins of a chiplet are reduced, a test link is shortened, test time is reduced, and test efficiency is improved.

To achieve the foregoing objectives, the following technical solutions are used in embodiments of this application.

According to a first aspect, an embodiment of this application provides a primary die. The primary die includes a primary test access port PTAP, a first auxiliary test access port STAP, and a second STAP. The first STAP is coupled to a first secondary die, and the second STAP is coupled to a second secondary die. The PTAP includes an input selection circuit and an output selection circuit. A test data input TDI port of the PTAP is coupled to a TDI port of the first STAP. The TDI port of the PTAP is further coupled to a first data input end of the input selection circuit. A second data input end of the input selection circuit is coupled to a test data output TDO port of the first STAP. An output end of the input selection circuit is coupled to a TDI port of the second STAP. The TDO port of the first STAP is coupled to a first data input end of the output selection circuit. A TDO port of the second STAP is coupled to a second data input end of the output selection circuit. An output end of the output selection circuit is coupled to a TDO port of the PTAP. The output selection circuit is configured to select an output test result of the first STAP or an output test result of the second STAP for output.

Therefore, the primary die provided in this embodiment of this application uses a PTAP-STAP architecture, and may be connected to an external device through only a pin of the PTAP, so that package pins of a chiplet are reduced. The second STAP may be coupled to the TDI port of the PTAP through the input selection circuit, and the first STAP is coupled to the TDI port of the PTAP. Therefore, input test data of the first STAP and the second STAP can come from a same source. This manner may be referred to as a broadcast mode, and no clamping logic design is required in this manner, so that design difficulty is reduced. The second STAP may be further coupled to the TDO port of the first STAP through the input selection circuit. That is, the primary die may be further compatible with a non-broadcast mode, so that applicability of the primary die is improved. In addition, the output selection circuit of the PTAP may select either of the output test results of the first STAP and the second STAP for output. This is different from a manner in which the output test results are serially output in that a test link can be shortened, test configuration time can be reduced, and test efficiency is improved.

In a possible design, the PTAP further includes a first register. The first register is configured to store a first value, where the first value indicates that the primary die is configured to be in the broadcast mode or the non-broadcast mode. Therefore, the first register is configured, so that the primary die can be compatible with the broadcast mode and the non-broadcast mode, and applicability of the primary die is improved.

In a possible design, a control end of the input selection circuit is coupled to an output end of the first register. The input selection circuit is configured to: when the primary die is configured to be in the broadcast mode, control input test data of the TDI port of the PTAP to be transmitted to the TDI port of the second STAP; and when the primary die is configured to be in the non-broadcast mode, control output test data of the TDO port of the first STAP to be transmitted to the TDI port of the second STAP. Therefore, when the primary die is configured to be in the broadcast mode, the input test data received by the TDI port of the PTAP is transmitted to the TDI port of the second STAP. Therefore, the input test data of the first STAP and the second STAP comes from the same source, and no clamping logic design is required, so that design difficulty is reduced.

In a possible design, the PTAP further includes a first multiplexer circuit, and the output selection circuit includes a second multiplexer and a third multiplexer. A first data input end of the first multiplexer is coupled to the TDI port of the PTAP, a second data input end of the first multiplexer is coupled to the TDO port of the second STAP, and an output end of the first multiplexer is coupled to a first data input end of the second multiplexer. A second data input end of the second multiplexer is coupled to the TDO port of the first STAP, and an output end of the second multiplexer is coupled to a first data input end of the third multiplexer. A second data input end of the third multiplexer is coupled to the TDO port of the second STAP, and an output end of the third multiplexer is coupled to the TDO port of the PTAP. Therefore, through the first multiplexer, the second multiplexer, and the third multiplexer, any one of a plurality of output test results can be selected for output, and parallel testing of a plurality of secondary dies can be implemented, so that test efficiency is improved. In addition, when a secondary die is not tested, the test link can be shortened, and test time can be reduced.

In a possible design, the PTAP further includes a second register, a third register, a first AND gate, and a second AND gate. A first input end of the first AND gate is coupled to an output end of the first register, a second input end of the first AND gate is coupled to an output end of the second register, and an output end of the first AND gate is coupled to a control end of the second multiplexer. A first input end of the second AND gate is coupled to the output end of the first register, a second input end of the second AND gate is coupled to an output end of the third register, and an output end of the second AND gate is coupled to a control end of the third multiplexer.

In a possible design, the second register is configured to store a second value, where the second value indicates that the TDO port of the first STAP and the TDO port of the PTAP are conducted or not conducted. The third register is configured to store a third value, where the third value indicates that the TDO port of the second STAP and the TDO port of the PTAP are conducted or not conducted. Therefore, through the second register, the third register, the first AND gate, and the second AND gate, the primary die can be compatible with the broadcast mode and the non-broadcast mode, so that applicability of the primary die is improved.

In a possible design, the PTAP further includes a fourth register, a fifth register, and an OR gate. A first input end of the OR gate is coupled to an output end of the fourth register, a second input end of the OR gate is coupled to an output end of the fifth register, and an output end of the OR gate is coupled to a control end of the first multiplexer. The fourth register is configured to store a fourth value, where the fourth value indicates that the first STAP is in a test state or an idle state. The fifth register is configured to store a fifth value, where the fifth value indicates that the second STAP is in a test state or an idle state. Therefore, through the fourth register and the fifth register, statuses of the STAPs may be configured according to a test requirement, so that test time is reduced, and test efficiency is improved.

According to a second aspect, an embodiment of this application further provides a test method. The test method is applied to a primary die, the primary die includes a PTAP and at least one STAP, and each STAP is coupled to one secondary die. The method includes: The PTAP sends input test data to the at least one STAP when the primary die is configured to be in a broadcast mode. The at least one STAP sends the received input test data to the secondary die. The at least one STAP receives output test data from the secondary die, where the output test data is obtained based on the input test data. The at least one STAP sends the output test data to the PTAP, and the PTAP selects one piece of output test data from at least one piece of output test data for output.

Therefore, in the test method provided in this embodiment of this application, a PTAP-STAP architecture is used, so that package pins of a chiplet are reduced. When the primary die is configured to be in the broadcast mode, the input test data may be sent to each STAP. In this way, input test data of STAPs can come from a same source, and no clamping logic design is required, so that design difficulty is reduced. In addition, when the secondary die is in a test state, the output test data may be directly sent to the PTAP, so that a test link is shortened and test time is reduced.

In a possible design, the method further includes: setting a first value stored in a first register of the primary die to a first level, where the first level indicates that the primary die is configured to be in the broadcast mode.

In a possible design, the at least one STAP includes a first STAP and a second STAP, and the method further includes: when the PTAP selects output test data of the first STAP for output, setting a second value stored in a second register of the primary die to a second level, where the second level indicates that a TDO port of the first STAP and a TDO port of the PTAP are conducted, or when the PTAP selects output test data of the second STAP for output, setting a third value stored in a third register of the primary die to a third level, where the third level indicates that a TDO port of the second STAP and a TDO port of the PTAP are conducted.

In a possible design, the method further includes: when a secondary die corresponding to the first STAP needs to be tested, setting a fourth value stored in a fourth register of the primary die to a fourth level, where the fourth level indicates that the first STAP is in a test state; or when a secondary die corresponding to the second STAP needs to be tested, setting a fifth value stored in a fifth register of the primary die to a fifth level, where the fifth level indicates that the second STAP is in a test state.

According to a third aspect, an embodiment of this application provides a chip package structure. The chip package structure includes a first secondary die, a second secondary die, an interconnection structure, and the primary die according to the first aspect. The first secondary die is coupled to the first STAP, and the second secondary die is coupled to the second STAP.

According to a fourth aspect, an embodiment of this application provides an electronic device. The electronic device includes the chip package structure according to the third aspect and a printed circuit board, and the chip package structure is disposed on the printed circuit board.

According to a fifth aspect, an embodiment of this application provides a computer-readable storage medium, including computer instructions. When the computer instructions are run on an electronic device, the electronic device is enabled to perform the test method according to the second aspect or any one of the possible implementations of the second aspect.

According to a sixth aspect, an embodiment of this application provides a computer program product. When the computer program product runs on a computer or a processor, the computer or the processor is enabled to perform the test method according to the second aspect or any one of the possible implementations of the second aspect.

It may be understood that any primary die, chip package structure, electronic device, computer-readable storage medium, computer program product, or the like provided above may be configured to perform the corresponding method provided above. Therefore, for beneficial effects that can be achieved by the primary die, the chip package structure, the electronic device, the computer-readable storage medium, the computer program product, or the like, refer to the beneficial effects in the corresponding method. Details are not described herein again.

These aspects or other aspects in this application are more concise and comprehensible in the following descriptions.

### BRIEF DESCRIPTION OF DRAWINGS

FIG. 1 is a diagram of connection of a 2D/2.5D chip according to an embodiment of this application;
FIG. 2 is a diagram of connection of another 2D/2.5D chip according to an embodiment of this application;
FIG. 3 is a diagram of connection of a 3D chip according to an embodiment of this application;
FIG. 4 is a diagram of connection of a chiplet according to an embodiment of this application;
FIG. 5 is a diagram of a structure of STAP controller logic according to an embodiment of this application;
FIG. 6 is a diagram of a PTAP-STAP structure of a primary die according to an embodiment of this application;
FIG. 7 is a diagram of test configuration of a chiplet according to an embodiment of this application;
FIG. 8 is a diagram of test configuration of another chiplet according to an embodiment of this application;
FIG. 9 is a diagram of a structure of a primary die according to an embodiment of this application;
FIG. 10 is a diagram of a structure of another primary die according to an embodiment of this application;
FIG. 11 is a diagram of a structure of still another primary die according to an embodiment of this application;
FIG. 12 is a diagram of test configuration of still another chiplet according to an embodiment of this application; and
FIG. 13 is a flowchart of a test method according to an embodiment of this application.

### DESCRIPTION OF EMBODIMENTS

For ease of understanding, some concepts related to embodiments of this application are described for reference by using examples. Details are as follows:

### 1. Definition of a JTAG pin in an IEEE 1149.1 standard

(1) TCK provides an independent and basic clock signal for an operation of a TAP, where the clock signal may drive all operations of the TAP.
(2) TMS is valid on a rising edge of the TCK and may be used to control switching of a TAP state machine. Specifically, a TMS signal may be used to control the TAP to switch between different states.
(3) TDI is a data input interface. Driven by the TCK, data may be serially input bit by bit to a specific register through the TDI interface.
(4) TDO is a data output interface. Driven by the TCK, data may be serially output bit by bit from a specific register through the TDO interface.
(5) TRST may also be represented as TRSTN, and is an optional interface in the IEEE 1149.1 standard. The TRST may be used to reset (initialize) a controller (controller) of the TAP. Alternatively, the TMS may be used to reset (initialize) the controller of the TAP.

### 2. 2D/2.5D chip-daisy chain (daisy chain) connection manner

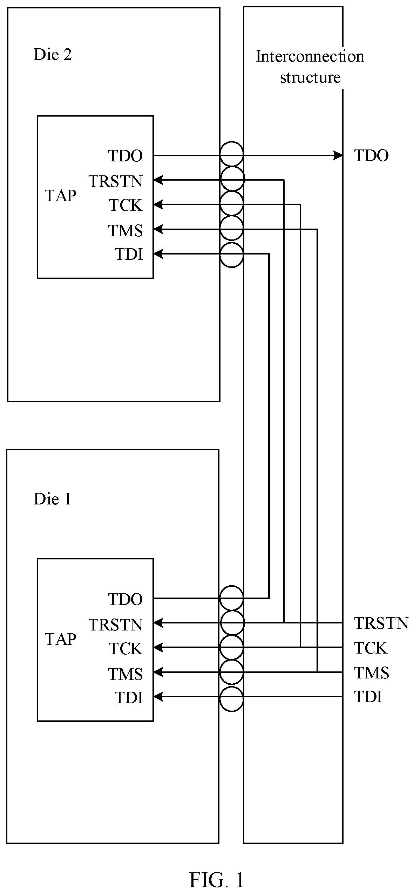

For the 2D/2.5D chip, a plurality of dies may be connected in series in a daisy chain manner, where TCK, TRSTN, and TMS may use a one-drive-many design in an interconnection structure (for example, a package substrate or an interposer (interposer)), and a path from TDI to TDO is connected in series between the dies. FIG. 1 shows a 2D/2.5D chip. The 2D/2.5D chip may include an interconnection structure and two dies (for example, a die 1 and a die 2). The 2D/2.5D chip is connected to an external device through a JTAG (for example, TDI, TMS, TCK, TRSTN, and TDO) of the interconnection structure. Some JTAG pins (for example, TMS, TCK, and TRSTN) of a TAP of the die 1 and some JTAG pins (for example, TMS, TCK, and TRSTN) of a TAP of the die 2 are separately connected to the JTAG of the interconnection structure. In addition, the TDI of the interconnection structure is connected to TDI in the TAP of the die 1, TDO in the TAP of the die 1 is connected to TDI in the TAP of the die 2, and TDO in the TAP of the die 2 is connected to the TDO of the interconnection structure.

### 3. 2D/2.5D chip-IEEE 1838 connection manner

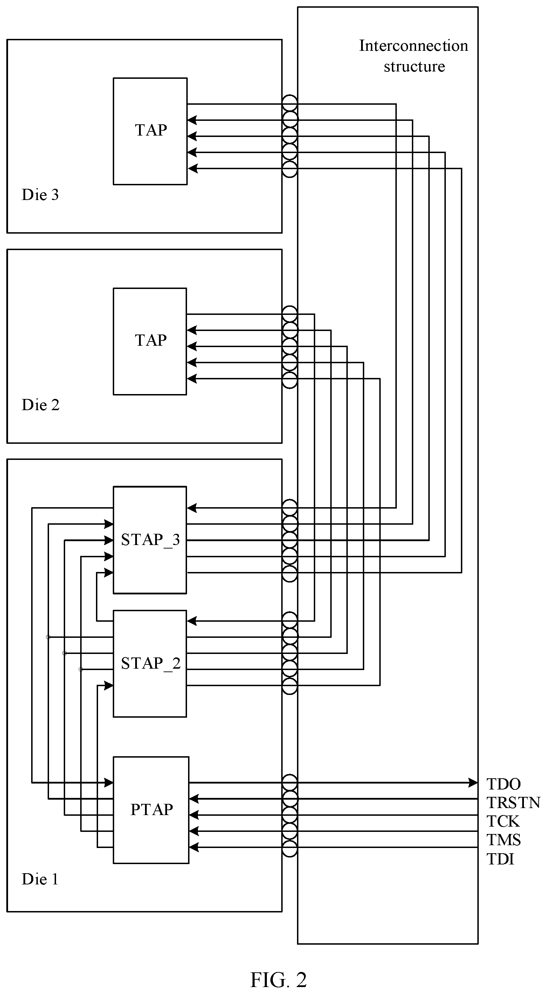

In addition to a daisy chain connection manner, a serial test access port (serial test access port, STAP) structure in an IEEE 1838 standard may also be used. As shown in FIG. 2, a primary die (for example, a die 1 in FIG. 2) controls TAPs of secondary dies (for example, a die 2 and a die 3 in FIG. 2) through a STAP, and an entire chiplet is connected to an external device through a set of JTAG (for example, TDI, TMS, TCK, TRSTN, and TDO). Specifically, the die 1 includes a primary test access port (primary test access port, PTAP), a STAP_2, and a STAP_3. A PTAP is separately coupled to the STAP_2 and the STAP_3. The STAP_2 is coupled to a TAP in the die 2 through an interconnection structure, and the STAP_3 is coupled to a TAP in the die 3 through the interconnection structure.

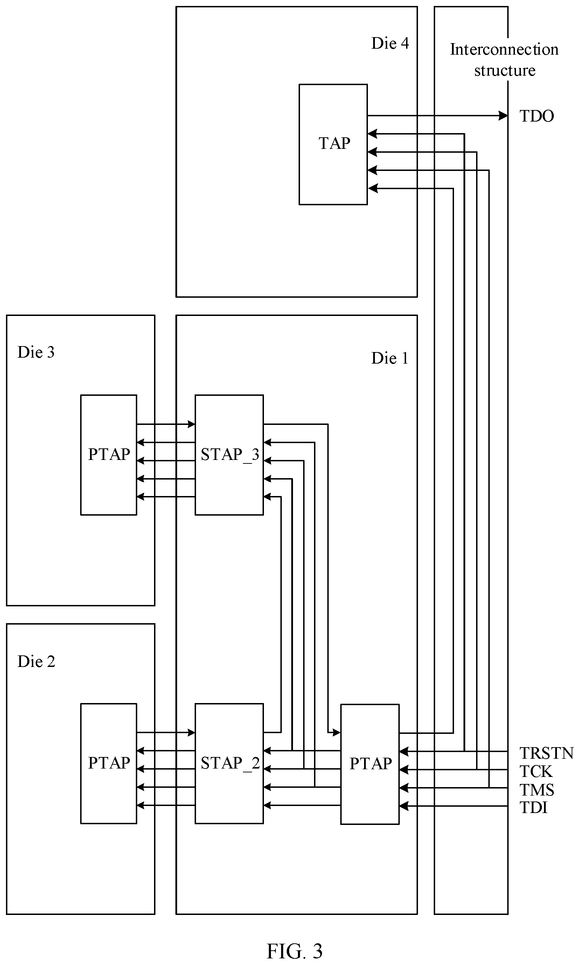

In addition, for a 3D chip, as shown in FIG. 3, the STAP structure in the IEEE 1838 standard may also be introduced to a test control interface. Specifically, the 3D chip may include a die 1, a die 2, a die 3, and a die 4. The die 1 and the die 2 are stacked in a 3D manner, and the die 1 and the die 3 are also stacked in a 3D manner. The die 1 serves as a primary die, and the die 2, the die 3, and the die 4 serve as secondary dies. The die 1 includes a PTAP, a STAP_2, and a STAP_3. The PTAP is coupled to a TAP in the die 4, the STAP_2 is coupled to a PTAP in the die 2, and the STAP_3 is coupled to a PTAP in the die 3.

The following describes the technical solutions in embodiments of this application with reference to the accompanying drawings in embodiments of this application. In description in embodiments of this application, "/" means "or" unless otherwise specified. For example, A/B may represent A or B. In this specification, "and/or" describes only an association relationship for describing associated objects and represents that three relationships may exist. For example, A and/or B may represent the following three cases: Only A exists, both A and B exist, and only B exists. In addition, in the descriptions in embodiments of this application, "a plurality of" means two or more.

The terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In descriptions of embodiments, unless otherwise specified, "a plurality of" means two or more.

When some embodiments are described, expressions of "coupling" and "connection" and their extensions may be used. For example, when some embodiments are described, the term "connection" may indicate that two or more components are in direct physical contact or electrical contact with each other. For another example, when some embodiments are described, the term "coupling" may indicate that two or more components are in direct physical contact or electrical contact with each other. However, the term "coupling" may alternatively indicate that two or more components are not in direct contact with each other, but still collaborate or interact with each other.

To reduce JTAG pins of a chiplet, a set of JTAG TAP connection structure (PTAP-STAP structure) between dies is proposed in the IEEE 1838 standard. Based on this structure, only one set of external JTAG interface pins is required for an entire chiplet, so that a problem of pin resource overheads is resolved.

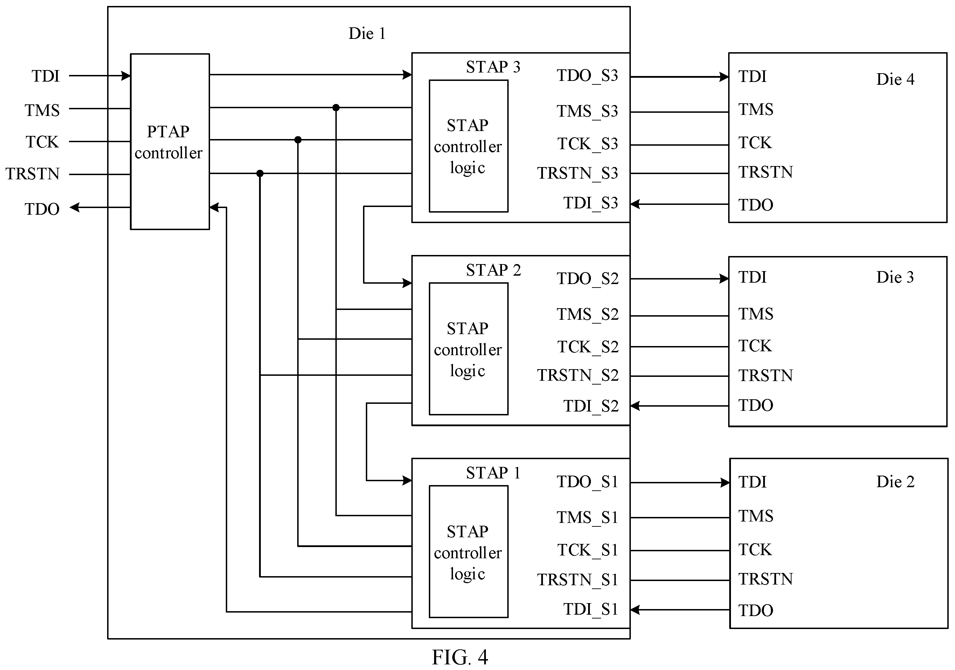

As shown in FIG. 4, a chiplet shown in FIG. 4 includes a die 1, a die 2, a die 3, and a die 4. Each die includes a PTAP and a STAP. FIG. 4 shows only a PTAP and STAPs of the die 1, but does not show PTAPs and STAPs of the die 2, the die 3, and the die 4 in detail. For the die 1 that serves as a primary die, the PTAP is an interface connected to an external input/output (input/output, I/O), and the STAP is an interface connected to a lower-level die. For the die 2, the die 3, and the die 4 that serve as secondary dies, the PTAP is an interface connected to an upper-level die, and the STAP is an interface connected to a lower-level die.

Specifically, the die 1 may include a PTAP controller (controller), a STAP 1, a STAP 2, and a STAP 3, and each STAP includes STAP controller logic (controller logic). The PTAP controller is connected to the external I/O through TDI, TMS, TCK, TRSTN, and TDO, and is coupled to the STAP 1, the STAP 2, and the STAP 3 through the foregoing pins. The STAP 1 is coupled to TDI, TMS, TCK, TRSTN, and TDO in the die 2 through TDO_S1, TMS_S1, TCK_S1, TRSTN_S1, and TDI_S1 respectively; the STAP 2 is coupled to TDI, TMS, TCK, TRSTN, and TDO in the die 3 through TDO_S2, TMS_S2, TCK_S2, TRSTN_S2, and TDI_S2 respectively; and the STAP 3 is coupled to TDI, TMS, TCK, TRSTN, and TDO in the die 4 through TDO_S3, TMS_S3, TCK_S3, TRSTN_S3, and TDI_S3 respectively.

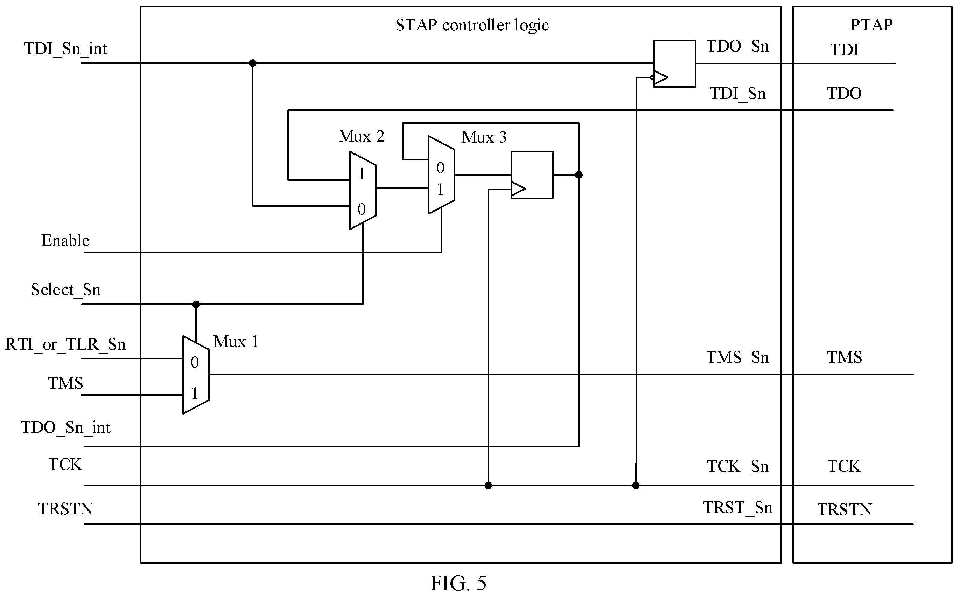

Specifically, a diagram of a structure of the STAP controller logic is shown as FIG. 5. The STAP controller logic is coupled to a PTAP. TCK_Sn, TMS_Sn, and TRST_Sn in the STAP controller logic are directly driven by TCK, TMS, and TRSTN in the PTAP. A retiming element (retiming element) may be added between the TDI_Sn and the TDO_Sn in the STAP controller logic and TDI and TDO of the PTAP to meet a timing requirement. The TMS, the TDI, and the TDO in the PTAP are connected to a lower-level die through a multiplexer (multiplexer, mux) only when the STAP controller logic is selected (that is, when Select_Sn=1).

FIG. 5 shows a mux 1, a mux 2, and a mux 3. A signal input by a first data input end of the mux 1 is RTI_or_TLR_Sn, a signal input by a second data input end of the mux 1 is TMS, and a signal input by a control end of the mux 1 is Select_Sn. A signal input by a first data input end of the mux 2 is TDI_Sn, a signal input by a second data input end of the mux 2 is TDI_Sn_int, and a signal input by a control end of the mux 2 is Select_Sn. A signal input by a first data input end of the mux 3 is TDO_Sn_int, a signal input by a second data input end of the mux 3 is a signal output by an output end of the mux 2, and a signal input by a control end of the mux 3 is an enable (Enable) signal.

It may be understood that, in FIG. 5, "1" is marked at the first data input end of the mux 1, and "0" is marked at the second data input end of the mux 1. That is, when the signal of the control end of the mux 1 is "0", the first data input end and an output end of the mux 1 are conducted; and when the signal of the control end of the mux 1 is "1", the second data input end and the output end of the mux 1 are conducted. Settings of a mux in the following are the same as those of the mux 1. Details are not described in the following.

Therefore, when Select_Sn=1, the second data input end and the output end of the mux 1 are conducted, and the TMS is transmitted to the PTAP as TMS_Sn. In addition, when Enable=1, the second data input end and an output end of the mux 3 are conducted, and the first data input end and the output end of the mux 2 are conducted. In this case, the TDO is transmitted to TDO_Sn_int.

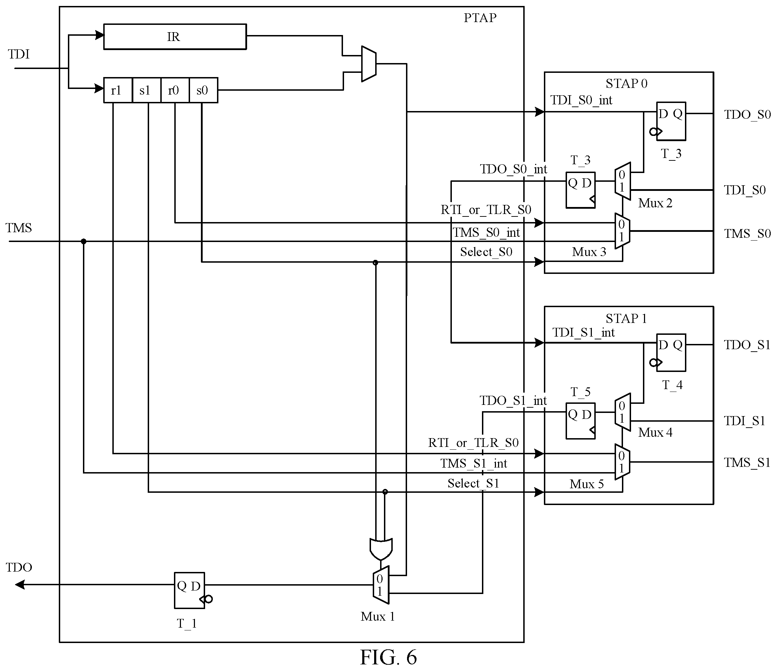

In an example, a PTAP-STAP structure of a primary die in the IEEE 1838 is shown in FIG. 6. A primary die shown in FIG. 6 may be coupled to two secondary dies. FIG. 6 shows a PTAP, a STAP 0, and a STAP 1. The PTAP may include an instruction register (instruction register, IR) and data registers (data registers, DRs). The data registers are, for example, r1, s1, r0, and s0. r1 and s1 are configured to control a die coupled to the STAP 1, and r0 and s0 are configured to control a die coupled to the STAP 0. In a possible example, when s0 is 0, a die coupled to the STAP 0 is not selected, and when s0 is 1, the die coupled to the STAP 0 is selected. When s1 is 0, a die coupled to the STAP 1 is not selected, and when s1 is 1, the die coupled to the STAP 1 is selected. Data stored in r0 and r1 is used to replace TMS when a STAP is not selected, to control a status of a die coupled to the STAP. The PTAP further includes an OR gate, a mux 1, and a trigger (represented by T_1 in FIG. 6). When no STAP is selected, that is, when s0=0, and s1=0, an output signal of an output end of the OR gate is 0, and TDI and TDO of the PTAP are conducted, and a signal received by using the TDI is transmitted to T_1.

Specifically, a TDI port of the STAP 0 may be represented as TDI_S0_int, a TDO port of the STAP 0 may be represented as TDO_S0_int, a TMS port of the STAP 0 may be represented as TMS_S0_int, a status port of the STAP 0 may be represented as RTI_or_TLR_S0, and an enable port of the STAP 0 may be represented as Select_S0. Ports, of the STAP 0, connected to a secondary die may be represented as TDO_S0, TDI_S0, and TMS_S0.

A TDI port of the STAP 1 may be represented as TDI_S1_int, a TDO port of the STAP 1 may be represented as TDO_S1_int, a TMS port of the STAP 1 may be represented as TMS_S1_int, a status port of the STAP 1 may be represented as RTI_or_TLR_S1, and an enable port of the STAP 1 may be represented as Select_S1. Ports, of the STAP 1, connected to the secondary die may be represented as TDO_S1, TDI_S1, and TMS_S1.

In addition, the STAP 0 may include two triggers (which are represented by T_2 and T_3 in FIG. 6), a mux 2, and a mux 3. Input test data of the TDI is transmitted to a subsequent die through T_2. Both control ends of the mux 2 and the mux 3 are coupled to an output end of the data register s0. When s0=0, that is, when the die coupled to the STAP 0 is not selected, an input end of T_3 and the TDI are conducted through the mux 2, and the input test data of the TDI is transmitted to the STAP 1 through T_3. In this case, data stored in the data register r0 is transmitted to the subsequent die through the mux 3. That is, the data stored in r0 replaces the TMS, to control a status of the die coupled to the STAP 0. When s0=1, that is, when the die coupled to the STAP 0 is selected, output test data received by the STAP 0 is transmitted to T_3 through the mux 2. In this case, the TMS is transmitted to the subsequent die through the mux 3, to control the status of the die coupled to the STAP 0.

The STAP 1 may include two triggers (which are represented by T_4 and T_5 in FIG. 6), a mux 4, and a mux 5. The input test data of the TDI is transmitted to the subsequent die through T_4. Both control ends of the mux 4 and the mux 5 are coupled to an output end of the data register s1. When s1=0, that is, when the die coupled to the STAP 1 is not selected, an input end of T_5 and the TDI are conducted through the mux 4, and the input test data of the TDI is transmitted to the PTAP through T_5. In this case, data stored in the data register r1 is transmitted to the subsequent die through the mux 5. That is, the data stored in r1 replaces the TMS, to control a status of the die coupled to the STAP 1. When s1=1, that is, when the die coupled to the STAP 1 is selected, output test data received by the STAP 1 is transmitted to T_5 through the mux 4. In this case, the TMS is transmitted to the subsequent die through the mux 5, to control the status of the die coupled to the STAP 1.

It can be learned that TAPs of dies in the PTAP-STAP structure are serially connected. Therefore, when a chiplet is tested, a three-dimensional configuration register (three-dimensional configuration register, 3DCR) may be configured, to control a multiplexer in the STAP, so that JTAG configuration is performed on a die that needs to be controlled in this test item, and a die that does not need to be configured can be directly bypassed (bypassed) in the STAP, to shorten a configuration link.

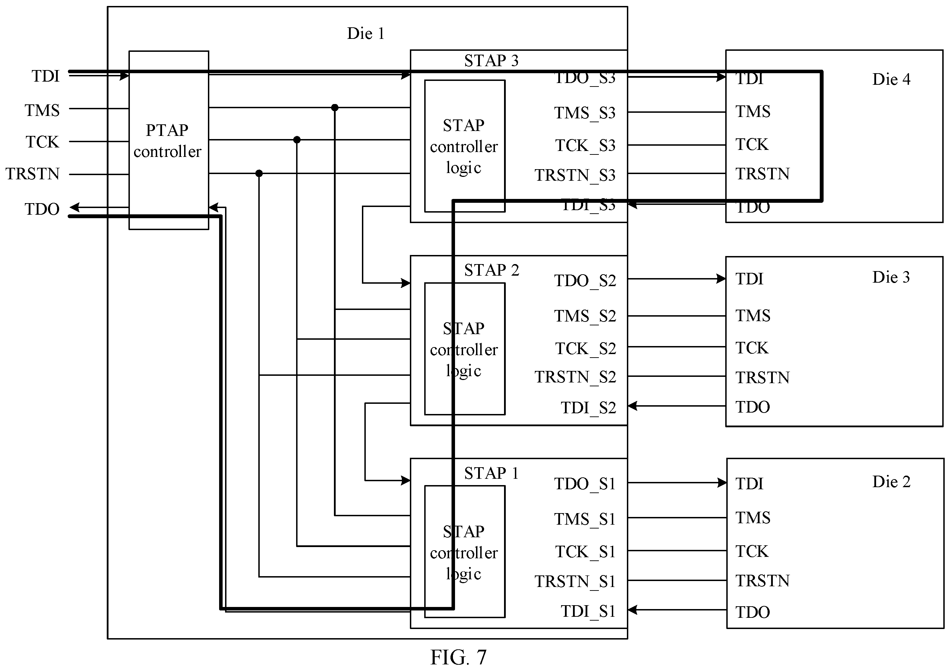

Based on the chiplet shown in FIG. 4, as shown in FIG. 7, assuming that the die that needs to be controlled in this case is the die 4, JTAG configuration may be performed on the die 4, and the die 2 and the die 3 are bypassed in the STAP. Specifically, a data flow direction of the JTAG configuration may be as follows: The PTAP controller in the die 1 receives input test data, and transmits the input test data to the STAP 3, and the STAP 3 transmits the input test data to the die 4 through the JTAG pin. The die 4 transmits, to TDI_S3 in the STAP 3 through the TDO interface, output test data obtained based on the input test data, and the STAP 3 sequentially transmits the output test data to STAP controller logic in the STAP 2 and STAP controller logic in the STAP 3, and finally transmits the output test data to the PTAP controller, to transmit the output test data externally through the TDO interface in the PTAP controller. Therefore, a test of the die 4 can be completed, and because the die 2 and the die 3 are bypassed, the configuration link can be shortened.

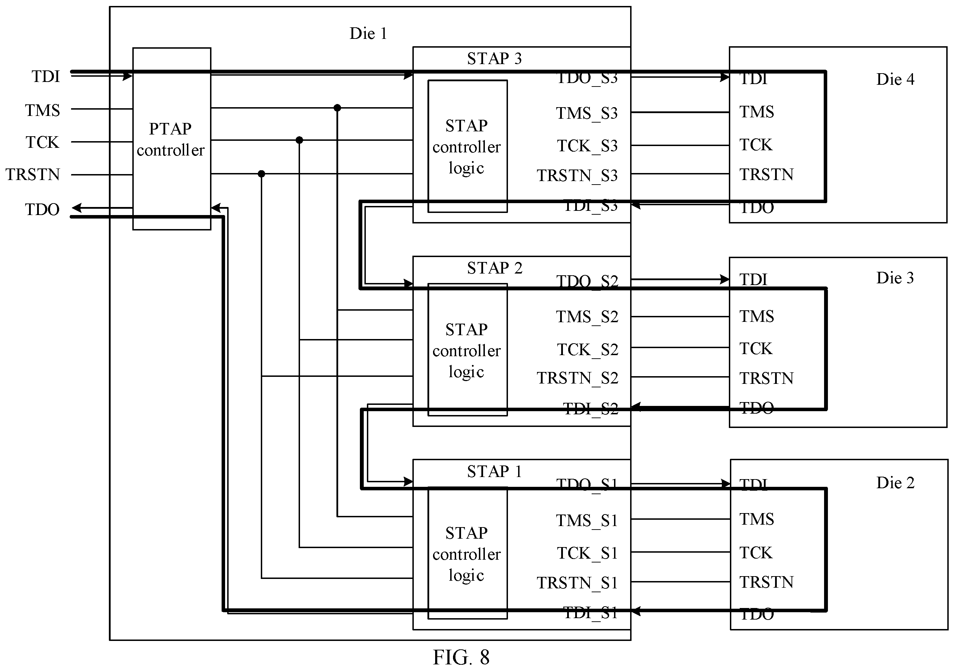

However, if test configuration of a plurality of dies needs to be started at the same time during a test, as shown in FIG. 8, assuming that the die 2, the die 3, and the die 4 need to be tested at the same time, a data flow direction of the JTAG configuration in this case may be as follows: the PTAP controller->the STAP 3->the die 4->the STAP 3->the STAP 2->the die 3->the STAP 2->the STAP 1->the die 2->the STAP 1->the PTAP controller. It can be learned that when the test configuration of the plurality of dies needs to be started at the same time, a test link is excessively long, and test efficiency is reduced.

Therefore, an embodiment of this application provides a primary die. The primary die includes a PTAP, a first STAP, and a second STAP. The primary die uses a PTAP-STAP architecture, and may be connected to an external device through only a pin of the PTAP, so that package pins of a chiplet are reduced. The second STAP may be coupled to a TDI port of the PTAP through an input selection circuit, and the first STAP is coupled to the TDI port of the PTAP. Therefore, input test data of the first STAP and the second STAP can come from a same source. This manner may be referred to as a broadcast mode, and no clamping logic design is required in this manner, so that design difficulty is reduced. The second STAP may be further coupled to a TDO port of the first STAP through the input selection circuit. That is, the primary die may be further compatible with a non-broadcast mode, so that applicability of the primary die is improved. In addition, an output selection circuit of the PTAP may select either of output test results of the first STAP and the second STAP for output. This is different from a manner in which the output test results are serially output in that a test link can be shortened, test configuration time can be reduced, and test efficiency is improved.

In the foregoing scenario, a chip package structure including the primary die provided in an embodiment of this application may be applied to an electronic device. The electronic device may be a mobile phone, a tablet computer, a desktop, a laptop, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR)/virtual reality (virtual reality, VR) device, or the like. A specific form of the electronic device is not specifically limited in embodiments of this application.

The chip package structure (which may also be referred to as a chiplet system) includes a plurality of dies that have a specific function and that may perform modular assembly with each other. For example, the dies may implement functions such as data storage, calculation, signal processing, and data stream management. Based on rich intellectual property core (intellectual property core, IP) reserves, the chiplet system proposes a concept of "IP as a chiplet" (IP as a Chiplet, IaaC), aiming at realizing, by using the dies, "plug-and-play" of an IP with a special function. For example, for some core processor IPs, the dies may be a graphics processing unit (Graphics Processing Unit, GPU) IP, a neural network processing unit (Neural-network Processing Unit, NPU) IP, a video processing unit (Video Processing Unit, VPU) IP, a digital signal processor (digital signal processor, DSP) IP, an image signal processor (Image Signal Processor, ISP) IP, a display processor IP, and the like. In addition, the dies may alternatively be a digital-analog hybrid IP, a radio frequency IP, and the like.

The chiplet system in this application may also be referred to as a small chip system or a chiplet system. That is, the die may also be referred to as a small chip or a chiplet.

For example, the chiplet system may be further applied to a system-on-a-chip (System-on-a-Chip, SoC), and dies with a plurality of functions are integrated on the SoC. For example, the chiplet system includes a first die and a second die. The first die may transmit service data/application data to the second die through a serial interface. The first die may further transmit a control signal to the second die through a sideband control channel.

The following describes the primary die provided in this embodiment of this application.

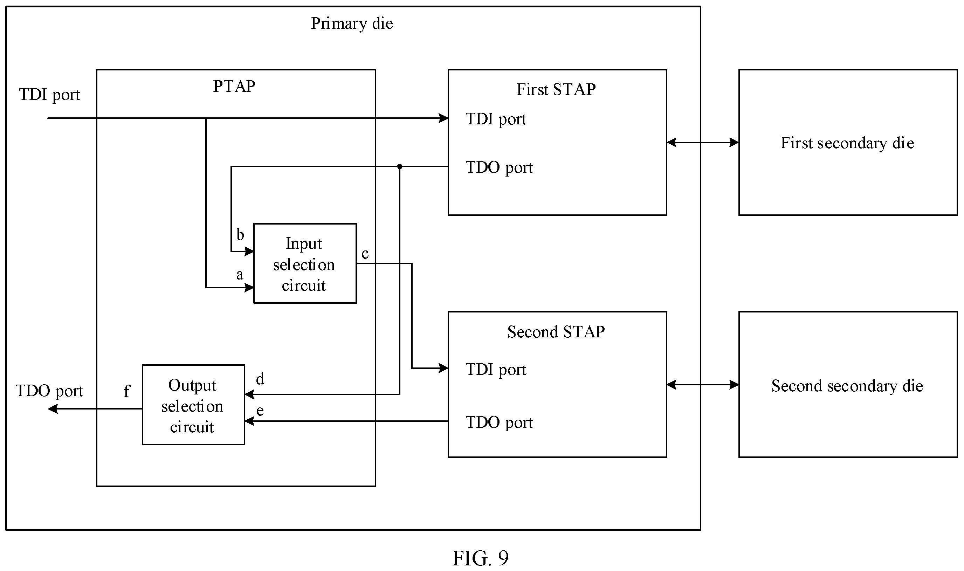

An embodiment of this application provides a primary die. As shown in FIG. 9, the primary die includes a PTAP, a first STAP, and a second STAP. The first STAP is coupled to a first secondary die, and the second STAP is coupled to a second secondary die.

For example, each secondary die may include a PTAP and a STAP. The first STAP is connected to a PTAP of the first secondary die, and the second STAP is connected to a PTAP of the second secondary die. The STAP of the secondary die may be connected to a PTAP of another secondary die.

For example, the primary die may send input test data to the first secondary die through the first STAP, and receive output test data from the first secondary die through the first STAP, to complete a test of the first secondary die. Similarly, the primary die may send the input test data to the second secondary die through the second STAP, and receive output test data from the second secondary die through the second STAP, to complete a test of the second secondary die.

The PTAP includes an input selection circuit and an output selection circuit. A TDI port of the PTAP is coupled to a TDI port of the first STAP. The TDI port of the PTAP is further coupled to a first data input end (represented by an input end a in FIG. 9) of the input selection circuit. A second data input end (represented by an input end b in FIG. 9) of the input selection circuit is coupled to a TDO port of the first STAP. An output end (represented by an output end c in FIG. 9) of the input selection circuit is coupled to a TDI port of the second STAP. The TDO port of the first STAP is coupled to a first data input end (represented by an input end d in FIG. 9) of the output selection circuit. A TDO port of the second STAP is coupled to a second data input end (represented by an input end e in FIG. 9) of the output selection circuit. An output end (represented by an output end f in FIG. 9) of the output selection circuit is coupled to a TDO port of the PTAP.

The output selection circuit is configured to select an output test result of the first STAP or an output test result of the second STAP for output.

For example, when the first data input end and the output end of the input selection circuit are conducted, the TDI port of the PTAP and both the TDI port of the first STAP and the TDI port of the second STAP are conducted. That is, the input test data of the first STAP and the second STAP comes from a same source. This manner may be referred to as a broadcast mode. That is, the PTAP broadcasts the received input test data to each STAP. In this case, no clamping logic design is required in a chiplet, so that design difficulty is reduced.

For example, when the first data input end and the output end of the input selection circuit are conducted, the TDO port of the first STAP and the TDI port of the second STAP are conducted. That is, the input test data of the second STAP comes from the first STAP, and the first STAP and the second STAP are in series. This manner may be referred to as a non-broadcast mode. Therefore, the input test data is selected by using the input selection circuit, so that the primary die can be compatible with the broadcast mode and the non-broadcast mode, and applicability of the chiplet is improved.

For example, when the first data input end and the output end of the output selection circuit are conducted, the output selection circuit selects the output test result of the first STAP for output. When the second data input end and the output end of the output selection circuit are conducted, the output selection circuit selects the output test result of the second STAP for output. In other words, the output selection circuit may select either of the output test results of the first STAP and the second STAP for output. This is different from a manner in which the output test results are serially output in that a test link can be shortened, test configuration time can be reduced, and test costs can be reduced.

It may be understood that the primary die, the first secondary die, and the second secondary die may further include other external pins, which are not shown in FIG. 9. This is not limited in this embodiment of this application.

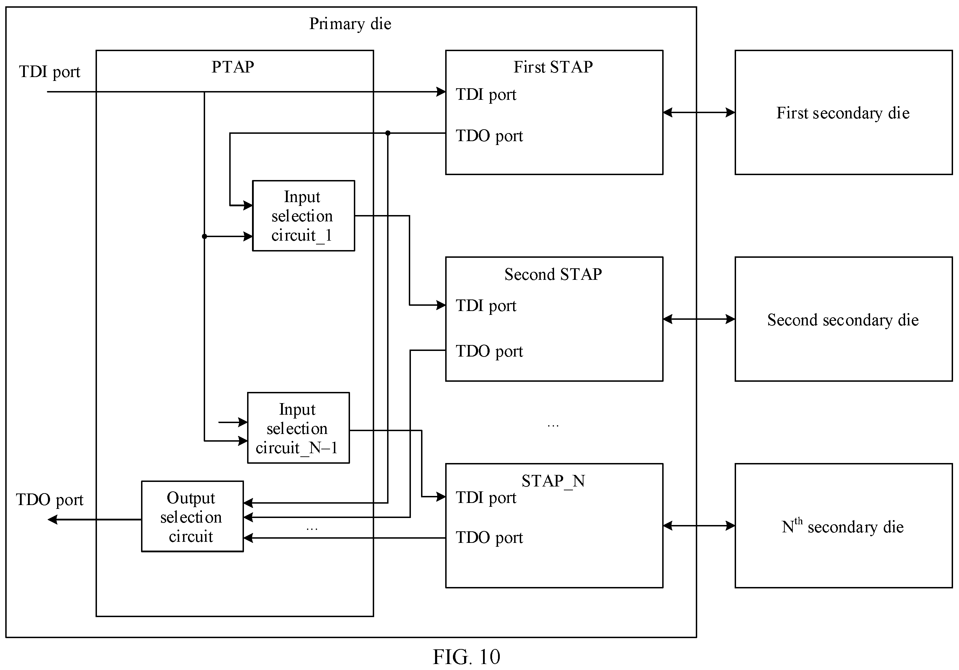

Optionally, as shown in FIG. 10, the primary die may further include more STAPs, for example, a first STAP, a second STAP, and a STAP_N shown in FIG. 10. N is an integer greater than 2, and each STAP is coupled to one secondary die. That is, the STAP_N is coupled to an N^{th} secondary die. The PTAP may include the output selection circuit and N-1 input selection circuits, and the N-1 input selection circuits may include an input selection circuit_1 to an input selection circuit_N-1. A first data input end of the input selection circuit_N-1 is coupled to the TDI port of the PTAP, and a second data input end of the input selection circuit_N-1 is coupled to a TDO port of the STAP_N-1 (not shown in FIG. 10).

In a possible implementation, the output selection circuit may include N data input ends, to select one output test result from output test results of N STAPs for output. In another possible implementation, the output selection circuit may further include N-1 cascaded multiplexers. That is, an output end of an upper-level multiplexer is coupled to a data input end of a current-level multiplexer. It may be understood that a structure of the output selection circuit may alternatively be in another form. This is not limited in this embodiment of this application.

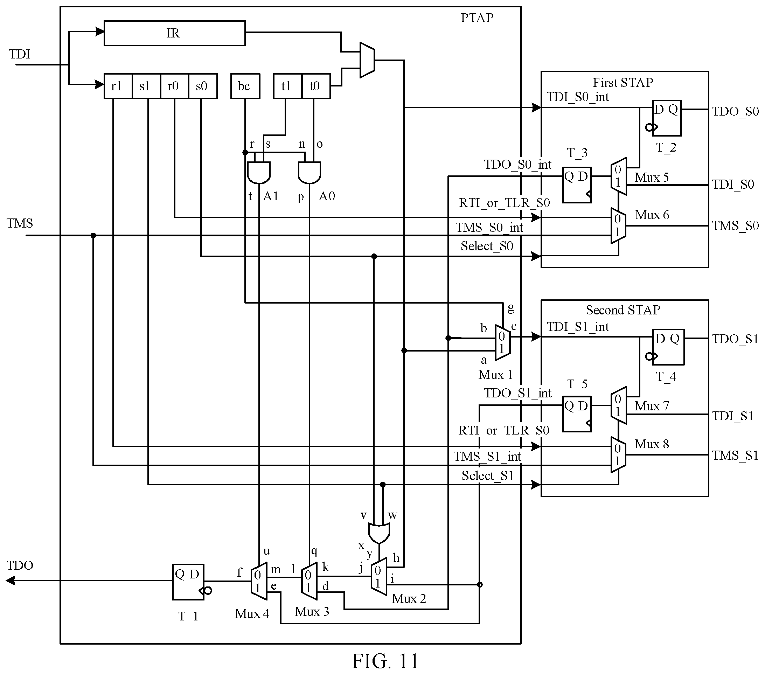

Optionally, as shown in FIG. 11, the PTAP may further include a first register. The first register is configured to store a first value, where the first value indicates that the primary die is configured to be in the broadcast mode or the non-broadcast mode. In other words, the first register may be a broadcast_enable (broadcast_enable, bc) register. In FIG. 11, "bc" represents the first register.

For example, the first value may be "0" or "1", or may be understood as a low level or a high level. In a possible implementation, when the first value is "0", the primary die is configured to be in the broadcast mode; and when the first value is "1", the primary die is configured to be in the non-broadcast mode. In another possible implementation, when the first value is "0", the primary die is configured to be in the non-broadcast mode; and when the first value is "1", the primary die is configured to be in the broadcast mode. This is not limited in this embodiment of this application.

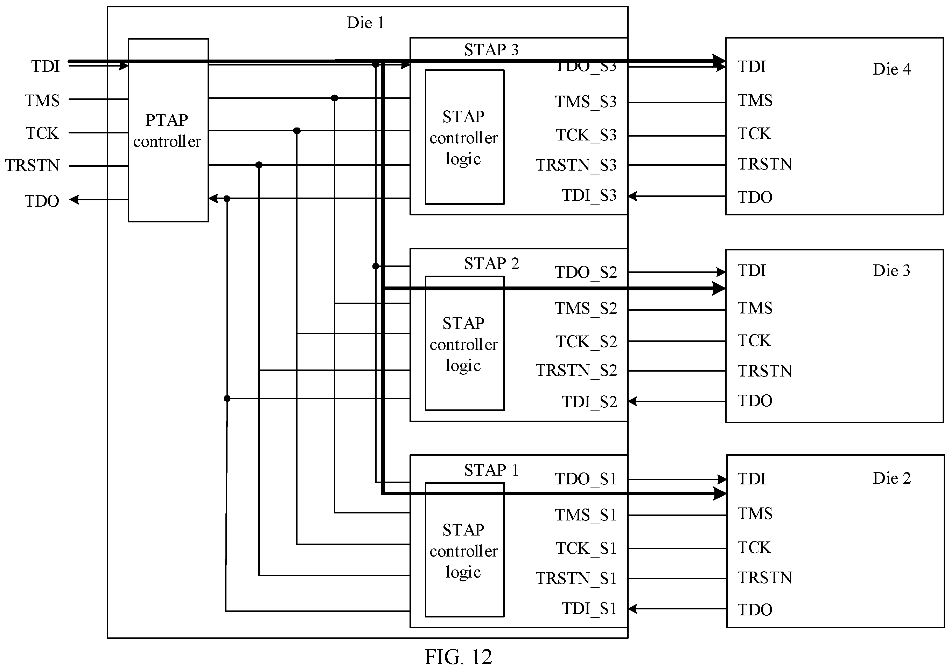

For example, the broadcast mode is shown in FIG. 12. FIG. 12 shows a die 1, a die 2, a die 3, and a die 4. Input test data received by a TDI port in the die 1 may be simultaneously broadcast to the die 2, the die 3, or the die 4. In this way, the chiplet can implement broadcast distribution of test configuration of a plurality of secondary dies, so that test parallelism of the secondary dies can be greatly improved, and test efficiency can be improved.

For example, for the non-broadcast mode, refer to a test mode shown in FIG. 7 or FIG. 8, that is, a serial configuration mode that meets the IEEE 1838 standard. It may be understood that the non-broadcast mode may alternatively be a test mode in another form. This is not limited in this embodiment of this application.

Optionally, still refer to FIG. 11. A control end (represented by a coupling end g in FIG. 11) of the input selection circuit (represented by a mux 1 in FIG. 11) is coupled to an output end of the first register. The input selection circuit is configured to: when the primary die is configured to be in the broadcast mode, control input test data of the TDI port of the PTAP to be transmitted to the TDI port of the second STAP; and when the primary die is configured to be in the non-broadcast mode, control output test data of the TDO port of the first STAP to be transmitted to the TDI port of the second STAP

For example, the input selection circuit may be a 2-to-1 multiplexer. A first data input end (represented by an input end a in FIG. 11) of the mux 1 is the first data input end of the input selection circuit, a second data input end (represented by an input end b in FIG. 11) of the mux 1 is the second data input end of the input selection circuit, and an output end (represented by an output end c in FIG. 11) of the mux 1 is the output end of the input selection circuit.

For example, the first value corresponding to the broadcast mode is "1" and the first value corresponding to the non-broadcast mode is "0". When the primary die is configured to be in the non-broadcast mode, the first value stored in the first register is set to "0". In this case, a value input by the control end of the input selection circuit is "0", and the second data input end and the output end of the input selection circuit are conducted. That is, the TDO port of the first STAP and the TDI port of the second STAP are conducted, and input test data of the TDO port of the first STAP is transmitted to the TDI port of the second STAP. When the primary die is configured to be in broadcast mode, the first value stored in the first register is set to "1". In this case, a value input by the control end of the input selection circuit is "1", and the first data input end and the output end of the input selection circuit are conducted. That is, the TDI port of the PTAP and the TDI port of the second STAP are conducted, and the input test data of the TDI port of the PTAP is transmitted to the TDI port of the second STAP.

Optionally, still refer to FIG. 11. The PTAP further includes a first multiplexer (represented by a mux 2 in FIG. 11), and the output selection circuit includes a second multiplexer (represented by a mux 3 in FIG. 11) and a third multiplexer (represented by a mux 4 in FIG. 11). In this embodiment of this application, the first multiplexer, the second multiplexer, and the third multiplexer may be 2-to-1 multiplexers.

A first data input end (represented by an input end h in FIG. 11) of the first multiplexer is coupled to the TDI port of the PTAP, a second data input end (represented by an input end i in FIG. 11) of the first multiplexer is coupled to the TDO port of the second STAP, and an output end (represented by an output end j in FIG. 11) of the first multiplexer is coupled to a first data input end (represented by an input end k in FIG. 11) of the second multiplexer. A second data input end (represented by an input end d in FIG. 11) of the second multiplexer is coupled to the TDO port of the first STAP, and an output end (represented by an output end l in FIG. 11) of the second multiplexer is coupled to a first data input end (represented by an input end m in FIG. 11) of the third multiplexer. A second data input end (represented by an input end e in FIG. 11) of the third multiplexer is coupled to the TDO port of the second STAP, and an output end (represented by an output end f in FIG. 11) of the third multiplexer is coupled to the TDO port of the PTAP.

It may be understood that the second data input end of the second multiplexer is the first data input end of the output selection circuit, the second data input end of the third multiplexer is the second data input end of the output selection circuit, and the output end of the third multiplexer is the output end of the output selection circuit.

It may be understood that the PTAP may further include a first trigger (represented by T_1 in FIG. 11), the first STAP includes a second trigger (represented by T_2 in FIG. 11) and a third trigger (represented by T_3 in FIG. 11), and the second STAP includes a fourth trigger (represented by T_4 in FIG. 11) and a fifth trigger (represented by T_5 in FIG. 11). The trigger may meet a timing requirement between the TDI port and the TDO port. In addition, the first STAP may further include a mux 5 and a mux 6, and the second STAP may further include a mux 7 and a mux 8.

In addition, port settings of the first STAP and the second STAP are the same as those of the STAP 0 and the STAP 1 in FIG. 6. Details are not described herein again.

Optionally, still refer to FIG. 11. The PTAP further includes a second register (represented by t0 in FIG. 11), a third register (represented by t1 in FIG. 11), a first AND gate (represented by A0 in FIG. 11), and a second AND gate (represented by A1 in FIG. 11).

A first input end (represented by an input end n in FIG. 11) of the first AND gate is coupled to the output end of the first register, a second input end (represented by an input end o in FIG. 11) of the first AND gate is coupled to the output end of the second register, and an output end (represented by an output end p in FIG. 11) of the first AND gate is coupled to a control end (represented by an input end q in FIG. 11) of the second multiplexer. A first input end (represented by an input end r in FIG. 11) of the second AND gate is coupled to the output end of the first register, a second input end (represented by an input end s in FIG. 11) of the first AND gate is coupled to the output end of the third register, and an output end (represented by an output end t in FIG. 11) of the second AND gate is coupled to a control end (represented by an input end u in FIG. 11) of the third multiplexer.

The second register is configured to store a second value, where the second value indicates that the TDO port of the first STAP and the TDO port of the PTAP are conducted or not conducted.

For example, the second value may be "0" or "1", or may be understood as a low level or a high level. In a possible implementation, when the second value is "0", the TDO port of the first STAP and the TDO port of the PTAP are conducted; and when the second value is "1", the TDO port of the first STAP and the TDO port of the PTAP are not conducted. In another possible implementation, when the second value is "1", the TDO port of the first STAP and the TDO port of the PTAP are conducted; and when the second value is "0", the TDO port of the first STAP and the TDO port of the PTAP are not conducted. This is not limited in this embodiment of this application.

The third register is configured to store a third value, where the third value indicates that the TDO port of the second STAP and the TDO port of the PTAP are conducted or not conducted.

For example, the third value may be "0" or "1", or may be understood as a low level or a high level. In a possible implementation, when the third value is "0", the TDO port of the second STAP and the TDO port of the PTAP are conducted; and when the third value is "1", the TDO port of the second STAP and the TDO port of the PTAP are not conducted. In another possible implementation, when the third value is "1", the TDO port of the second STAP and the TDO port of the PTAP are conducted; and when the third value is "0", the TDO port of the second STAP and the TDO port of the PTAP are not conducted. This is not limited in this embodiment of this application.

For example, when the primary die is configured to be in the broadcast mode, that is, when the first value stored in the first register is "1", if the second value stored in the second register is "1", the first AND gate outputs "1", or if the second value stored in the second register is "0", the first AND gate outputs "0"; and if the third value stored in the third register is "1", the second AND gate outputs "1", or if the third value stored in the third register is "0", the second AND gate outputs "0".

Settings of the mux 3 and the mux 4 in FIG. 11 are used as examples. When the primary die is configured to be in the broadcast mode, and the input selection circuit selects the output test result of the first STAP for output, t0=1, and t1=0. In this case, the first AND gate outputs "1", and the second AND gate outputs "0". In other words, a value of a control end of the mux 3 is "1". In this case, a second data input end and an output end of the mux 3 are conducted, and the output test result of the first STAP is transmitted to the mux 4. Because a value of a control end of the mux 4 is "0", a first data input end and an output end of the mux 4 are conducted in this case, and the mux 4 transmits the output test result of the first STAP to T_1, to transmit the output test result externally through the TDO port of the PTAP.

When the primary die is configured to be in the broadcast mode, and the input selection circuit selects the output test result of the second STAP for output, t0=0, and t1=1. In this case, the first AND gate outputs "0", and the second AND gate outputs "1". In other words, a value of a control end of the mux 4 is "1", a second data input end and an output end of the mux 4 are conducted, and the output test result of the second STAP is transmitted to T_1, to be transmitted externally through the TDO port of the PTAP.

Optionally, still refer to FIG. 11. The PTAP further includes a fourth register (represented by s0 in FIG. 11), a fifth register (represented by s1 in FIG. 11), and an OR gate. The fourth register and the fifth register may be configured to control output of the output test result of the first STAP or output of the output test result of the second STAP in the broadcast mode. Therefore, the fourth register and the fifth register may be referred to as output selection registers, and may be represented by tdo_sel. In addition, the PTAP may further include a sixth register (represented by r0 in FIG. 11) and a seventh register (represented by r1 in FIG. 11), and values stored in r0 and r1 are usually "0".

A first input end (represented by an input end v in FIG. 11) of the OR gate is coupled to the output end of the fourth register, a second input end (represented by an input end w in FIG. 11) of the OR gate is coupled to the output end of the fifth register, and an output end (represented by an output end x in FIG. 11) of the OR gate is coupled to a control end (represented by an input end y in FIG. 11) of the first multiplexer.

The fourth register is configured to store a fourth value, where the fourth value indicates that the first STAP is in a test state or an idle (idle) state.

For example, the fourth value may be "0" or "1", or may be understood as a low level or a high level. In a possible implementation, when the fourth value is "0", the first STAP is in the test state; and when the fourth value is "1", the first STAP is in the idle state. In another possible implementation, when the fourth value is "1", the first STAP is in the test state; and when the fourth value is "0", the first STAP is in the idle state. This is not limited in this embodiment of this application.

The fifth register is configured to store a fifth value. The fifth value indicates that the second STAP is in a test state or an idle state.

For example, the fifth value may be "0" or "1", or may be understood as a low level or a high level. In a possible implementation, when the fifth value is "0", the second STAP is in the test state; and when the fifth value is "1", the second STAP is in the idle state. In another possible implementation, when the fifth value is "1", the second STAP is in the test state; and when the fifth value is "0", the second STAP is in the idle state. This is not limited in this embodiment of this application.

The first STAP is used as an example. When s0=1, signals Select_S0 of control ends of the mux 5 and the mux 6 are equal to 1, TDI_S0 and T_3 are conducted through the mux 5, and TMS_S0_int and TMS_S0 are conducted through the mux 6. In other words, when the first STAP is in the test state, input test data received by TDI_S0_int is transmitted to the first secondary die through T_2 and TDO_S0, and output test data sent by the first secondary die is transmitted to T_3 through TDI_S0 and the mux 5. In addition, when s0=0, the signals Select_S0 of the control ends of the mux 5 and the mux 6 are equal to 0, TDI_S0_int and T_3 are conducted through the mux 5, and RTI_or_TLR_S0 and TMS_S0 are conducted through the mux 6. In other words, when the first STAP is in the idle state, the input test data received by TDI_S0_int is transmitted to a subsequent secondary die through the mux 5 and T_3, and RTI_or_TLR_S0 replaces TMS_S0_int to control a status of the first die. A configuration manner of the second STAP is similar to that of the first STAP. Details are not described herein again. It may be understood that configuration of the fourth register and the fifth register by the primary die may be understood as the foregoing 3DCR configuration, and the multiplexer in the STAP may be controlled, so that JTAG configuration is performed on a secondary die that needs to be controlled in this test item, and a secondary die that does not needs to be configured can be directly bypassed in the STAP, to shorten a configuration link. A quantity of registers in a 3DCR may be determined based on a quantity of secondary dies.

It may be understood that, the second register and the fourth register are used as examples, and a user needs to refer to the configuration of the fourth register when configuring the second register. In a possible example, when the first STAP controlled by the fourth register is in the idle state, the second value stored in the second register should not be configured to indicate that the TDO port of the first STAP and the TDO port of the PTAP are conducted.

The example is applied to the primary die in FIG. 11. When the primary die tests a plurality of secondary dies at the same time, the primary die performs a parallel write operation. The primary die may set the first register be to 1. The primary die further sets, through the 3DCR, a register corresponding to a STAP in a test state to 1, that is, s*=1, where "*" may be replaced with a number; and sets a register corresponding to a STAP not in the test state to 0, that is, s*=0, and all r*=0.

Correspondingly, when the primary die performs a read operation, the primary die may set the first register be to 1, and the primary die may further select a STAP to be read through tdo_sel. For the STAP to be read, the primary die sets corresponding s* in the 3DCR to 1 and r* to 0. For another unread STAP, if corresponding s* in the 3DCR is equal to 1, a TAP in the STAP performs a same operation as a TAP in a read STAP; and if the corresponding s* in the 3DCR is equal to 0 and r* is equal to 0, the TAP in the STAP is in an idle state. The user may determine a configuration manner according to a requirement.

The following describes a test method provided in an embodiment of this application.

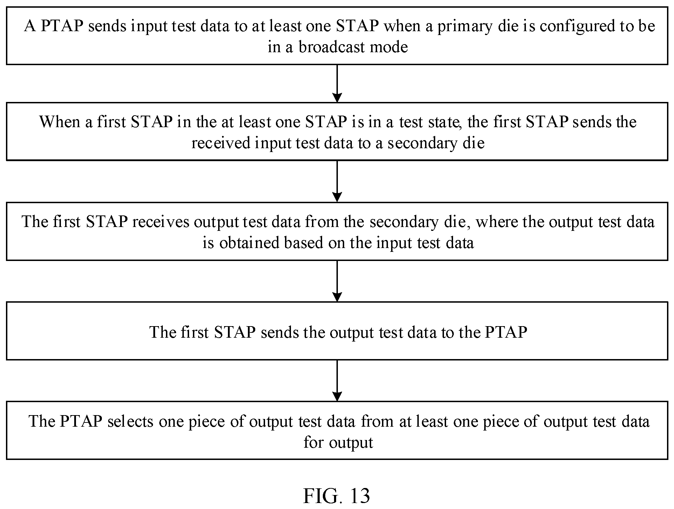

An embodiment of this application provides a test method. As shown in FIG. 13, the test method is applied to a primary die. The primary die includes a PTAP and at least one STAP, and each STAP is coupled to one secondary die. The method includes the following procedure.

In a possible implementation, the PTAP sends input test data to the at least one STAP when the primary die is configured to be in a broadcast mode.

For example, it is assumed that when a first value stored in a first register is "1", it indicates a broadcast mode, and when the stored first value is "0", it indicates a non-broadcast mode. When a plurality of secondary dies need to be tested at the same time, to shorten a test link and improve test efficiency, the primary die may be configured to be in the broadcast mode. Specifically, the primary die sets the first value stored in the first register to "1", so that the PTAP can broadcast the input test data to each STAP through a TDI port. In another possible implementation, the at least one STAP sends the received input test data to the secondary die. In still another possible implementation, the at least one STAP receives output test data from the secondary die, where the output test data is obtained based on the input test data.

For example, the primary die may configure a status of each secondary die through a 3DCR configuration register. It is assumed that when a value stored in a register of the primary die is "1", the secondary die performs a write operation or a read operation; and when the value stored in the register of the primary die is "0", the secondary die does not perform the write operation or the read operation, that is, the secondary die is in an idle state. Therefore, a user may determine a configuration manner according to a requirement, to send the input test data to a STAP connected to a secondary die that needs to be written to, and receive the output test data from a STAP connected to a secondary die that needs to be read. In still another possible implementation, the at least one STAP sends the output test data to the PTAP.

In still another possible implementation, the PTAP selects one piece of output test data from at least one piece of output test data for output.

For example, after receiving the output test data, the STAP sends the output test data to the PTAP. The PTAP may select, based on configuration of the register, the one piece of output test data from the at least one piece of output test data for output. In a possible example, it is assumed that when the value stored in the register is "1", the output test result is selected for output; and when the value stored in the register is "0", the output test result is not selected for output. Therefore, the user may determine the configuration of the register according to a requirement, and set a value in a register corresponding to output of a required output test result to "1", to output the required output test result.

Therefore, because the primary die uses a PTAP-STAP architecture, the primary die may be connected to an external device through only a pin of the PTAP, so that package pins of a chiplet are reduced. The input test data of the at least one STAP comes from a same source, and no clamping logic design is required, so that design difficulty is reduced. In addition, an output selection circuit of the PTAP may select any one of a plurality of output test results for output. This is different from a manner in which the output test results are serially output in that a test link can be shortened, test configuration time can be reduced, and test costs can be reduced. Because the primary die may be in the broadcast mode, test parallelism of the plurality of secondary dies can be improved, test configuration time can be greatly reduced, and test costs can be reduced.

Optionally, the test method further includes: setting the first value stored in the first register of the primary die to a first level, where the first level indicates that the primary die is configured to be in the broadcast mode.

For example, the first level may be a high level, and the high level may be represented by "1". When the first value is "1", the primary die is configured to be in the broadcast mode. The first level may alternatively be a low level, and the low level may be represented by "0". When the first value is "0", the primary die is configured to be in the broadcast mode. Therefore, the first register may be configured, so that the primary die is compatible with the broadcast mode and the non-broadcast mode, and applicability of the primary die is improved.

Optionally, the at least one STAP includes a first STAP and a second STAP, and the test method further includes: when the PTAP selects output test data of the first STAP for output, setting a second value stored in a second register of the primary die to a second level, where the second level indicates that a TDO port of the first STAP and a TDO port of the PTAP are conducted.

For example, the second level may be a high level, and the high level may be represented by "1". When the second value is "1", the TDO port of the first STAP and the TDO port of the PTAP are conducted, and the PTAP selects the output test data of the first STAP for output. The second level may be a low level, and the low level may be represented by "0". When the second value is "0", the TDO port of the first STAP and the TDO port of the PTAP are conducted, and the PTAP selects the output test data of the first STAP for output Therefore, the second register may be configured, so that the primary die is compatible with the broadcast mode and the non-broadcast mode, and applicability of the primary die is improved.

Optionally, the test method further includes: when the PTAP selects output test data of the second STAP for output, setting a third value stored in a third register of the primary die to a third level, where the third level indicates that a TDO port of the second STAP and a TDO port of the PTAP are conducted.

For example, the third level may be a high level, and the high level may be represented by "1". When the third value is "1", the TDO port of the second STAP and the TDO port of the PTAP are conducted, and the PTAP selects the output test data of the second STAP for output. The third level may be a low level, and the low level may be represented by "0". When the third value is "0", the TDO port of the second STAP and the TDO port of the PTAP are conducted, and the PTAP selects the output test data of the second STAP for output. Therefore, the third register may be configured, so that the primary die is compatible with the broadcast mode and the non-broadcast mode, and applicability of the primary die is improved.

Optionally, the test method further includes: when a secondary die corresponding to the first STAP needs to be tested, setting a fourth value stored in a fourth register of the primary die to a fourth level, where the fourth level indicates that the first STAP is in a test state.

For example, the fourth level may be a high level, and the high level may be represented by "1". When the fourth value is "1", the first STAP is in the test state. The fourth level may be a low level, and the low level may be represented by "0". When the fourth value is "0", the first STAP is in the test state. Therefore, through the fourth register, the primary die may configure a status of the STAP according to a test requirement, so that test time is reduced, and test efficiency is improved.

Optionally, the test method further includes: when a secondary die corresponding to the second STAP needs to be tested, setting a fifth value stored in a fifth register of the primary die to a fifth level, where the fifth level indicates that the second STAP is in a test state.

For example, the fifth level may be a high level, and the high level may be represented by "1". When the fifth value is "1", the second STAP is in the test state. The fifth level may be a low level, and the low level may be represented by "0". When the fifth value is "0", the second STAP is in the test state. Therefore, through the fifth register, the primary die may configure a status of the STAP according to a test requirement, so that test time is reduced, and test efficiency is improved.

An embodiment of this application further provides a chip package structure. The chip package structure includes a first secondary die, a second secondary die, an interconnection structure, and the primary die described above. The first secondary die is coupled to a first STAP, and the second secondary die is coupled to a second STAP

An embodiment of this application further provides an electronic device. The electronic device includes a chip package structure and a printed circuit board, and the chip package structure is disposed on the printed circuit board.

It may be understood that, to implement the foregoing functions, the electronic device includes a corresponding hardware and/or software module for performing each function. With reference to algorithm steps of examples described in embodiments disclosed in this specification, this application can be implemented in a form of hardware or a combination of hardware and computer software. Whether a function is performed by hardware or hardware driven by computer software depends on particular applications and design constraints of the technical solutions. A person skilled in the art may use different methods to implement the described functions for each particular application with reference to embodiments, but it should not be considered that the implementation goes beyond the scope of this application.

An embodiment of this application further provides a computer storage medium. The computer storage medium stores computer instructions. When the computer instructions are run on an electronic device, the electronic device is enabled to perform the related method steps, to implement the test method in the foregoing embodiments.

An embodiment of this application further provides a computer program product. When the computer program product runs on a computer, the computer is enabled to perform the foregoing related steps, to implement the test method performed by the electronic device in the foregoing embodiments.

In addition, an embodiment of this application further provides an apparatus. The apparatus may be specifically a chip, a component, or a module. The apparatus may include a processor and a memory that are connected. The memory is configured to store computer-executable instructions. When the apparatus runs, the processor may execute the computer-executable instructions stored in the memory, so that the chip performs the test method performed by the electronic device in the foregoing method embodiments.

The primary die, the chip package structure, the electronic device, the computer storage medium, the computer program product, or the chip provided in embodiments is configured to perform the corresponding method provided above. Therefore, for beneficial effects that can be achieved by the primary die, the chip package structure, the electronic device, the computer storage medium, the computer program product, or the chip, refer to the beneficial effects in the corresponding method provided above. Details are not described herein again.

Based on the descriptions about the foregoing implementations, a person skilled in the art may understand that, for a purpose of convenient and brief description, division into the foregoing functional modules is used as an example for illustration. In actual application, the foregoing functions may be allocated to different functional modules and implemented according to a requirement. In other words, an inner structure of an apparatus is divided into different functional modules to implement all or some of the functions described above.

In several embodiments provided in this application, it should be understood that the disclosed apparatus and method may be implemented in other manners. For example, the described apparatus embodiments are merely examples. For example, the division into modules or units is merely logical function division and may be other division during actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may be one or more physical units, may be located in one place, or may be distributed on different places. Some or all of the units may be selected according to actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of software functional unit.

When the integrated unit is implemented in the form of software functional unit and sold or used as an independent product, the integrated unit may be stored in a readable storage medium. Based on such an understanding, the technical solutions of embodiments of this application essentially, or the part contributing to a conventional technology, or all or some of the technical solutions may be implemented in a form of software product. The software product is stored in a storage medium and includes several instructions for instructing a device (which may be a single-chip microcomputer, a chip, or the like) or a processor (processor) to perform all or some of steps of methods in embodiments of this application. The storage medium includes various media that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art in the technical scope disclosed in this application shall fall within the protection scope of this application. Therefore, the protection scope of this application shall be subject to the protection scope of the claims.

## Claims

1. A primary die, comprising: a primary test access port, PTAP, a first auxiliary test access port, STAP, and a second STAP, wherein the first STAP is coupled to a first secondary die, and the second STAP is coupled to a second secondary die; and
the PTAP comprises an input selection circuit and an output selection circuit, wherein
a test data input, TDI, port of the PTAP is coupled to a TDI port of the first STAP, the TDI port of the PTAP is further coupled to a first data input end of the input selection circuit, a second data input end of the input selection circuit is coupled to a test data output, TDO, port of the first STAP, and an output end of the input selection circuit is coupled to a TDI port of the second STAP;
the TDO port of the first STAP is coupled to a first data input end of the output selection circuit, a TDO port of the second STAP is coupled to a second data input end of the output selection circuit, and an output end of the output selection circuit is coupled to a TDO port of the PTAP; and
the output selection circuit is configured to select an output test result of the first STAP or an output test result of the second STAP for output.

2. The primary die according to claim 1, wherein the PTAP further comprises a first register; and
the first register is configured to store a first value, wherein the first value indicates that the primary die is configured to be in a broadcast mode or a non-broadcast mode.

3. The primary die according to claim 2, wherein
a control end of the input selection circuit is coupled to an output end of the first register; and
the input selection circuit is configured to: when the primary die is configured to be in the broadcast mode, control input test data of the TDI port of the PTAP to be transmitted to the TDI port of the second STAP; and when the primary die is configured to be in the non-broadcast mode, control output test data of the TDO port of the first STAP to be transmitted to the TDI port of the second STAP.

4. The primary die according to any one of claims 1 to 3, wherein the PTAP further comprises a first multiplexer circuit, and the output selection circuit comprises a second multiplexer and a third multiplexer;
a first data input end of the first multiplexer is coupled to the TDI port of the PTAP, a second data input end of the first multiplexer is coupled to the TDO port of the second STAP, and an output end of the first multiplexer is coupled to a first data input end of the second multiplexer;
a second data input end of the second multiplexer is coupled to the TDO port of the first STAP, and an output end of the second multiplexer is coupled to a first data input end of the third multiplexer; and
a second data input end of the third multiplexer is coupled to the TDO port of the second STAP, and an output end of the third multiplexer is coupled to the TDO port of the PTAP.

5. The primary die according to claim 4, wherein the PTAP further comprises a second register, a third register, a first AND gate, and a second AND gate, wherein
a first input end of the first AND gate is coupled to an output end of the first register, a second input end of the first AND gate is coupled to an output end of the second register, and an output end of the first AND gate is coupled to a control end of the second multiplexer; and
a first input end of the second AND gate is coupled to the output end of the first register, a second input end of the second AND gate is coupled to an output end of the third register, and an output end of the second AND gate is coupled to a control end of the third multiplexer.

6. The primary die according to claim 5, wherein
the second register is configured to store a second value, wherein the second value indicates that the TDO port of the first STAP and the TDO port of the PTAP are conducted or not conducted; and
the third register is configured to store a third value, wherein the third value indicates that the TDO port of the second STAP and the TDO port of the PTAP are conducted or not conducted.

7. The primary die according to any one of claims 4 to 6, wherein the PTAP further comprises a fourth register, a fifth register, and an OR gate, wherein
a first input end of the OR gate is coupled to an output end of the fourth register, a second input end of the OR gate is coupled to an output end of the fifth register, and an output end of the OR gate is coupled to a control end of the first multiplexer;
the fourth register is configured to store a fourth value, wherein the fourth value indicates that the first STAP is in a test state or an idle state; and
the fifth register is configured to store a fifth value, wherein the fifth value indicates that the second STAP is in a test state or an idle state.

8. A test method, wherein the test method is applied to a primary die, the primary die comprises a primary test access port, PTAP, and at least one auxiliary test access port, STAP, each STAP is coupled to one secondary die, and the method comprises:
sending, by the PTAP, input test data to the at least one STAP when the primary die is configured to be in a broadcast mode;
sending, by the at least one STAP, the received input test data to the secondary die;
receiving, by the at least one STAP, output test data from the secondary die, wherein the output test data is obtained based on the input test data;
sending, by the at least one STAP, the output test data to the PTAP; and
selecting, by the PTAP, one piece of output test data from at least one piece of output test data for output.

9. The method according to claim 8, wherein the method further comprises:
setting a first value stored in a first register of the primary die to a first level, wherein the first level indicates that the primary die is configured to be in the broadcast mode.

10. The method according to claim 8 or 9, wherein the at least one STAP comprises a first STAP and a second STAP, and the method further comprises:
when the PTAP selects output test data of the first STAP for output, setting a second value stored in a second register of the primary die to a second level, wherein the second level indicates that a test data output, TDO port of the first STAP and a TDO port of the PTAP are conducted; or
when the PTAP selects output test data of the second STAP for output, setting a third value stored in a third register of the primary die to a third level, wherein the third level indicates that a TDO port of the second STAP and a TDO port of the PTAP are conducted.

11. The method according to claim 10, wherein the method further comprises:
when a secondary die corresponding to the first STAP needs to be tested, setting a fourth value stored in a fourth register of the primary die to a fourth level, wherein the fourth level indicates that the first STAP is in a test state; or
when a secondary die corresponding to the second STAP needs to be tested, setting a fifth value stored in a fifth register of the primary die to a fifth level, wherein the fifth level indicates that the second STAP is in a test state.

12. A chip package structure, comprising a first secondary die, a second secondary die, an interconnection structure, and the primary die according to any one of claims 1 to 7, wherein
the first secondary die is coupled to the first STAP, and the second secondary die is coupled to the second STAP

13. An electronic device, comprising the chip package structure according to claim 12 and a printed circuit board, wherein
the chip package structure is disposed on the printed circuit board.
